# EUROPEAN PATENT APPLICATION

(11) **EP 4 654 761 A2**
(43) Date of publication of application: **26.11.2025**
(21) Application number: 25163818.5
(22) Date of filing: 14.03.2025
(51) Int. Cl.: H05K 3/46, H05K 3/00, H05K 3/06, H05K 3/36, H05K 3/40

(54) **METHOD FOR MANUFACTURING MULTILAYER SUBSTRATE**

(30) Priority: 24.05.2024 JP 2024085026
(71) Applicant: FICT LIMITED, Nagano-shi, Nagano 381-8501 (JP)
(72) Inventor: OZAKI, Norikazu, Nagano-shi, Nagano, 381-8501 (JP); MIYAGAWA, Tetsurou, Nagano-shi, Nagano, 381-8501 (JP); NAKAGAWA, Takashi, Nagano-shi, Nagano, 381-8501 (JP); SAKAI, Naoki, Nagano-shi, Nagano, 381-8501 (JP)
(74) Representative: Hoffmann Eitle

(57) **Abstract**

A layered body (56) is manufactured by etching a first foil (12) constituting a three-layer metal foil (10) to form a first metal layer (22) shaped like a pattern, stacking a first insulating layer (26) so as to bury the first metal layer (22), forming a first via (34) as a plated via, forming a second metal layer (40) shaped like a pattern on the first insulating layer (26), stacking a second insulating layer (42) so as to bury the second metal layer (40), removing a second foil (14) and a third foil (16) constituting the three-layer metal foil (10), stacking a third insulating layer (48) and a resin film (50) on the second insulating layer (42), and providing a second via (54) as a paste via to the second insulating layer (42), and a multilayer substrate (100) is obtained by stacking a plurality of layered bodies (56).

## Description

### Technical Field

The present invention relates to a method for manufacturing a multilayer substrate.

### Background Art

A circuit board (hereinafter referred to as a "multilayer substrate" in some cases) having a multilayer structure is widely known to the public.

For example, in PTL 1 (JP-A-2023-136298), there is disclosed a multilayer substrate having layers which are interlayer-coupled with a plated via in a plurality of insulating layers, and layers which are interlayer-coupled with a paste via filled with a conductive paste.

According to this multilayer substrate, it is assumed that it is possible to decrease a value of a resistance between the layers to increase an allowable current value since the multilayer substrate includes not only the interlayer coupling with the conductive paste but also the interlayer coupling with the plated via.

Further, according to the method for manufacturing the multilayer substrate described in PTL 1, it is disclosed that a three-layer metal foil obtained by stacking three layers of metal foil is bonded to both surfaces of a support body, and the substrates are built into the three-layer metal foils on both surfaces of the support body.

### Summary of Invention

### Technical Problem

As described above, in the manufacturing method disclosed in PTL 1, there is adopted a step of building the substrates simultaneously into the two three-layer metal foils bonded to the both surfaces of the support body, but according to this method, there is a problem that a manufacturing apparatus grows in size to therefore incur an increase in cost.

Further, although it is necessary to hold the support body and the three-layer metal foils in vacuum, when a gap supposedly occurs between the support body and the three-layer metal foil, chemical or the like is apt to infiltrate into the gap, and there is a concern that a crack may occur.

### Solution to Problem

Therefore, the present invention is made to solve the problem described above, and the object thereof is to provide a method for manufacturing a multilayer substrate capable of manufacturing the multilayer substrate while preventing an increase in cost in the manufacturing process, and preventing a crack from occurring.

That is, according to a method for manufacturing a multilayer substrate in the disclosure, there are included manufacturing a layered body including etching a first foil constituting a three-layer metal foil to form a first metal layer which is shaped like a pattern and is formed of the first foil, stacking a first insulating layer on the first metal layer so as to bury the first metal layer, stacking a metal layer shaped like a flat plate on the first insulating layer, forming a first through hole which penetrates the metal layer shaped like a flat plate and the first insulating layer and reaches the first metal layer, applying filled plating to the first through hole to form a first via as a plated via, etching the metal layer shaped like a flat plate to form a second metal layer shaped like a pattern, stacking a second insulating layer on the second metal layer shaped like the pattern so as to bury the second metal layer shaped like the pattern, removing a second foil and a third foil constituting the three-layer metal foil, stacking a third insulating layer and a resin film on the second insulating layer, forming a second through hole which penetrates the third insulating layer, the resin film, and the second insulating layer and reaches the second metal layer, and filling the second through hole with a conductive paste to form a second via as a paste via, and separating the resin films in a plurality of layered bodies, then bonding the first insulating layer of one layered body and the second insulating layer of another layered body to each other, and then curing the third insulating layer to thereby obtain the multilayer substrate which is formed by stacking the plurality of layered bodies.

According to this method, the manufacturing can be achieved without growing the manufacturing apparatus in size compared to the related art, and it is possible to prevent the crack of the substrate in the manufacturing process from occurring.

Further, performing half etching of reducing a thickness of the second metal layer after the applying the filled plating to the first through hole to form the plated via is included.

According to this method, since the second metal layer becomes thick when performing the filled plating, it is possible to provide the second metal layer with an appropriate thickness before forming the second metal layer shaped like a pattern.

Further, after the stacking the second insulating layer on the second metal layer shaped like the pattern so as to bury the second metal layer shaped like the pattern, stacking a metal foil on the second insulating layer, pressure-bonding the second insulating layer in a semi-cured state to the second metal layer and the first insulating layer, and removing the metal foil after the pressure-bonding are executed.

According to this method, it is possible to obtain the layered body by planarizing the surface of the second insulating layer, and surely bonding the second insulating layer to the second metal layer shaped like the pattern and the first insulating layer.

### Advantageous Effects of Invention

According to the present invention, since manufacturing can be achieved without growing the manufacturing apparatus in size, it is possible to realize a method for manufacturing a multilayer substrate capable of preventing an increase in cost, and preventing the crack in the manufacturing process from occurring.

### Brief Description of Drawings

Fig. 1 is a schematic cross-sectional view showing an example of a multilayer substrate manufactured by a method for manufacturing a multilayer substrate in the present embodiment.
Fig. 2 is a schematic cross-sectional view (number 1) showing an example of a method for manufacturing a multilayer substrate in the present embodiment.
Fig. 3 is a schematic cross-sectional view (number 2) showing an example of the method for manufacturing the multilayer substrate in the present embodiment.
Fig. 4 is a schematic cross-sectional view (number 3) showing an example of the method for manufacturing the multilayer substrate in the present embodiment.
Fig. 5 is a schematic cross-sectional view (number 4) showing an example of the method for manufacturing the multilayer substrate in the present embodiment.
Fig. 6 is a schematic cross-sectional view (number 5) showing an example of the method for manufacturing the multilayer substrate in the present embodiment.
Fig. 7 is a schematic cross-sectional view (number 6) showing an example of the method for manufacturing the multilayer substrate in the present embodiment.
Fig. 8 is a schematic cross-sectional view (number 7) showing an example of the method for manufacturing the multilayer substrate in the present embodiment.
Fig. 9 is a schematic cross-sectional view (number 8) showing an example of the method for manufacturing the multilayer substrate in the present embodiment.
Fig. 10 is a schematic cross-sectional view (number 9) showing an example of the method for manufacturing the multilayer substrate in the present embodiment.
Fig. 11 is a schematic cross-sectional view (number 10) showing an example of the method for manufacturing the multilayer substrate in the present embodiment.
Fig. 12 is a schematic cross-sectional view (number 11) showing an example of the method for manufacturing the multilayer substrate in the present embodiment.
Fig. 13 is a schematic cross-sectional view (number 12) showing an example of the method for manufacturing the multilayer substrate in the present embodiment.
Fig. 14 is a schematic cross-sectional view (number 13) showing an example of the method for manufacturing the multilayer substrate in the present embodiment.
Fig. 15 is a schematic cross-sectional view (number 14) showing an example of the method for manufacturing the multilayer substrate in the present embodiment.
Fig. 16 is a schematic cross-sectional view (number 15) showing an example of the method for manufacturing the multilayer substrate in the present embodiment.
Fig. 17 is a schematic cross-sectional view (number 16) showing an example of the method for manufacturing the multilayer substrate in the present embodiment.
Fig. 18 is a schematic cross-sectional view (number 17) showing an example of the method for manufacturing the multilayer substrate in the present embodiment.
Fig. 19 is a schematic cross-sectional view (number 18) showing an example of the method for manufacturing the multilayer substrate in the present embodiment.
Fig. 20 is a schematic cross-sectional view (number 19) showing an example of the method for manufacturing the multilayer substrate in the present embodiment.
Fig. 21 is a schematic cross-sectional view (number 20) showing an example of the method for manufacturing the multilayer substrate in the present embodiment.

### Description of Embodiments

A method for manufacturing a multilayer substrate 100 in the present embodiment will hereinafter be described in detail with reference to the drawings.

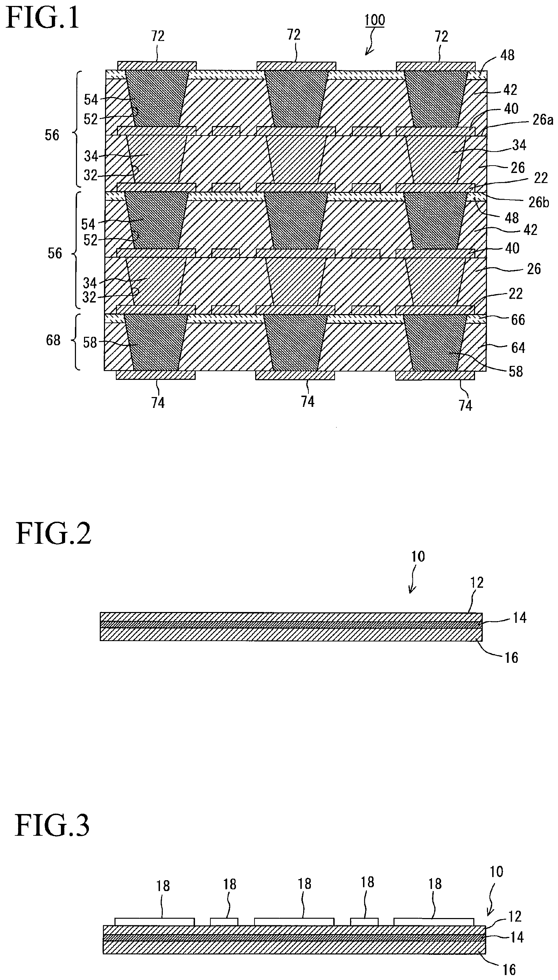

Fig. 1 shows a schematic cross-sectional view of the multilayer substrate 100 which is manufactured with the manufacturing method according to the present embodiment.

Further, in the multilayer substrate 100, an "upper surface" or a "lower surface" is described in some cases based on a vertical direction in the drawings for the sake of convenience, and the upper surface and the lower surface in the multilayer substrate 100 include when the upper surface and the lower surface do not coincide with an actual vertical direction. Further, in the multilayer substrate 100, a "side surface" is described in some cases, and the side surface means a side surface with reference to the upper surface and the lower surface described above.

### (Multilayer Substrate)

As shown in Fig. 1, the multilayer substrate 100 according to the present embodiment has a configuration in which a plurality of layered bodies 56 is stacked on one another. More specifically, the multilayer substrate 100 is provided with the plurality of layered bodies 56, a metal layer 72, and a layered body 68, wherein the metal layer 72 is patterned and located in an uppermost layer, and the layered body 68 is located in a lowermost layer.

Each of the layered bodies 56 has a first insulating layer 26, a second insulating layer 42, and a third insulating layer 48, wherein the second insulating layer 42 is stacked at a first surface 26a (an upper surface in Fig. 1) side of the first insulating layer 26, and the third insulating layer 48 is stacked on an upper surface of the second insulating layer 42.

In each of the layered bodies 56, a second metal layer 40 shaped like a pattern is formed on the first surface 26a of the first insulating layer 26, and a first metal layer 22 shaped like a pattern is formed in a second surface 26b. The second metal layer 40 is embedded in the second insulating layer 42 located on the upper surface of the first insulating layer 26, and the first metal layer 22 is embedded in the first insulating layer 26.

First vias 34 penetrating the first insulating layer 26 are plated vias, and electrically couple the second metal layer 40 and the first metal layer 22 to each other.

Further, in each of the layered bodies 56, second vias 54 penetrating the third insulating layer 48 and the second insulating layer 42 are paste vias filled with a conductive paste, and electrically couple the second metal layer 40 and the first metal layer 22 of another layered body 56 to each other.

The third insulating layer 48 stacked on an upper surface of the second insulating layer 42 has a role as an adhesive layer when stacking another layered body 56.

When the number of metal layers is an even number, the multilayer substrate 100 includes the layered body 68, which is different from the layered bodies 56 described above, stacked as the lowermost layer.

The layered body 68 has, as an example, a fourth insulating layer 64, a fifth insulating layer 66, and third vias 58, wherein a lower surface metal layer 74 shaped like a pattern is formed on a lower surface of the fourth insulating layer 64, the fifth insulating layer 66 is stacked on the fourth insulating layer 64, and the third vias 58 are formed so as to penetrate the fourth insulating layer 64 and the fifth insulating layer 66. Further, the lower surface metal layer 74 is electrically coupled to the first metal layer 22 in the lower surface of the layered body 56 located immediately above via the third vias 58.

The fifth insulating layer 66 has a role as an adhesive layer when stacking the layered body 56 located immediately above.

Further, paste vias filled with substantially the same conductive paste as in the second vias 54 described above can be used as the third vias 58.

It is preferable for the lower surface metal layer 74 to be exposed from the fourth insulating layer 64.

When the number of metal layers is an odd number, the layered body 68 described above is not stacked, and the multilayer substrate 100 is different in configuration of the layered body 56 as the lowermost layer (not shown). Specifically, it is preferable for the first metal layer 22 of the layered body 56 as the lowermost layer to be exposed from the first insulating layer 26.

### (Method for Manufacturing Multilayer Substrate)

The method for manufacturing the multilayer substrate 100 will hereinafter be described in detail.

As shown in Fig. 2, first, a three-layer metal foil 10 is prepared. As an example, in the three-layer metal foil 10, a copper foil 12, a metal foil 14 different from the copper foil 12, and a metallic support body (in particular a copper support body) 16 are stacked on one another in this order. The metal foil 14 is not particularly limited as long as the metal foil can selectively be etched with a selective etchant which is not reactive to the copper foil 12 and the copper support body 16, and can appropriately be selected for purposes. It should be noted that a first foil referred to in the appended claims corresponds to the copper foil 12, a second foil corresponds to the metal foil 14, and a third foil corresponds to the metallic support body 16.

Then, as shown in Fig. 3 to Fig. 5, the first metal layer 22 is provided to the three-layer metal foil 10.

Specifically, as shown in Fig. 3, a dry film resist 18 shaped like a film is attached to a surface of the copper foil 12, and is then exposed with a predetermined pattern corresponding to the pattern of the first metal layer 22 to remove unwanted portions.

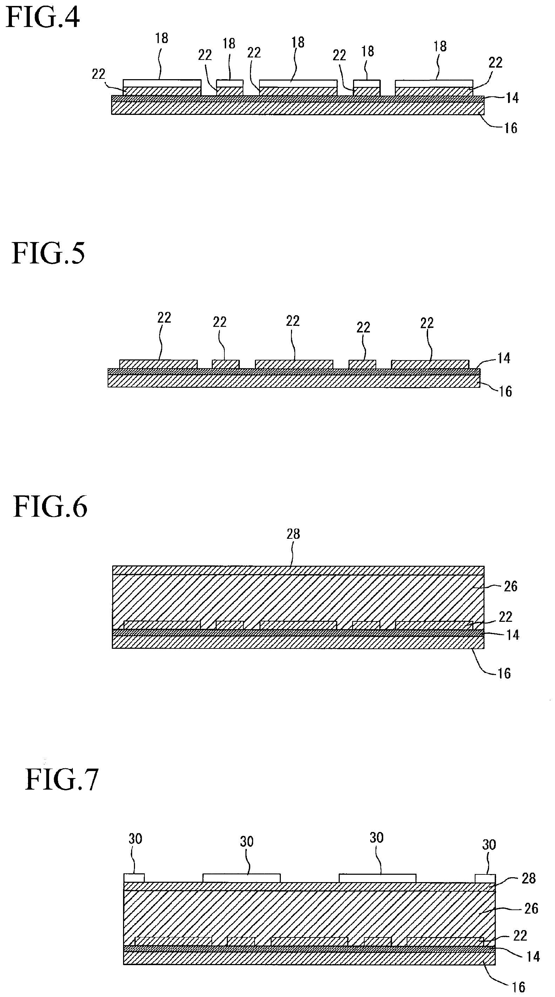

Then, as shown in Fig. 4, etching (half etching) is performed to thereby form the copper foil 12 into the first metal layer 22 shaped like a predetermined pattern.

Subsequently, as shown in Fig. 5, the dry film resist 18 is removed from the surface of the first metal layer 22.

It should be noted that the first metal layer 22 is formed to have a thickness of about 10 µm to 60 µm as an example, but this is not a limitation, and the thickness can appropriately be selected for purposes.

Further, it is possible to perform a surface roughening treatment on the first metal layer 22 to thereby improve the adhesiveness to the first insulating layer 26 when stacking the first insulating layer 26 described below.

Then, as shown in Fig. 6, the first insulating layer 26 is stacked on the first metal layer 22 so as to bury the first metal layer 22. Subsequently, a metal layer 28 shaped like a flat plate is stacked on the first insulating layer 26.

The first insulating layer 26 is normally shaped like a flat plate. An average thickness of the first insulating layer 26 may be no smaller than 10 µm and no larger than 200 µm, or may be no smaller than 30 µm and no larger than 100 µm, but is not particularly limited, and can appropriately be selected for purposes.

Further, the first insulating layer 26 is not particularly limited as long as the first insulating layer 26 is an insulating layer used in multilayer substrates, and can appropriately be selected for purposes. As an example, a base material reinforced in hardness with an inorganic base material such as inorganic woven cloth or inorganic unwoven cloth using glass cloth or the like, or an organic base material such as organic woven cloth or organic unwoven cloth can be adopted as the first insulating layer 26.

Further, as an example, a glass epoxy base material (a glass woven base material impregnated with epoxy resin, a glass unwoven base material impregnated with epoxy resin), a glass woven base material impregnated with bismaleimide triazine resin, an aramid unwoven base material impregnated with epoxy resin, and a glass woven base material impregnated with modified polyphenylene ether resin can be adopted as the first insulating layer 26.

It should be noted that, for example, copper can be adopted as the metal layer 28 shaped like a flat plate to be stacked on the first insulating layer 26.

Then, as shown in Fig. 7 to Fig. 11, the first vias 34 are provided to the first insulating layer 26.

Specifically, first, as shown in Fig. 7, a dry film resist 30 shaped like a film is attached to a surface of the metal layer 28, and portions corresponding to openings of first through holes 32 of the first vias 34 are exposed to remove unwanted portions.

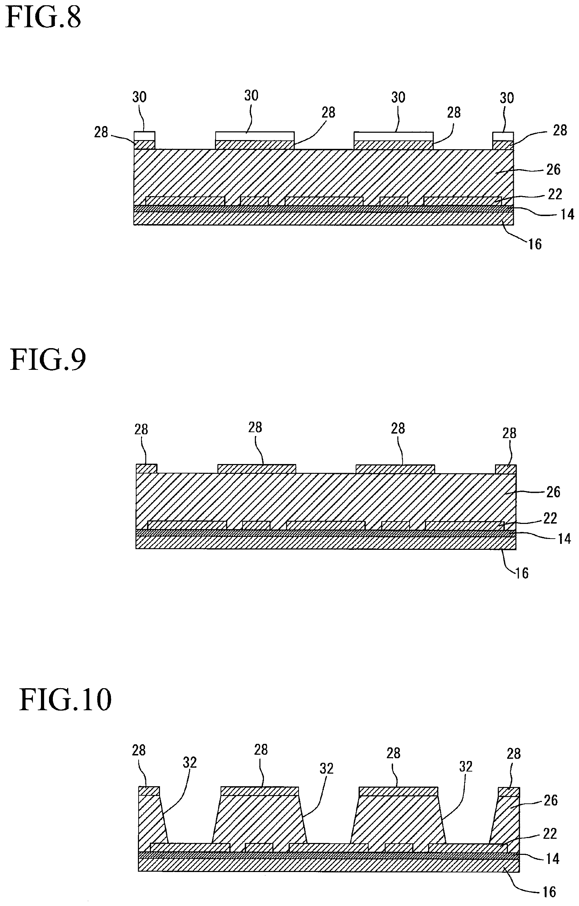

Then, as shown in Fig. 8, etching (half etching) is performed to thereby remove portions corresponding to the first through holes 32 from the metal layer 28 to form the metal layer 28 except the portions corresponding to the first through holes 32.

Subsequently, as shown in Fig. 9, the dry film resist 30 is removed from the surface of the metal layer 28.

Then, as shown in Fig. 10, first through holes 32 as bottomed holes penetrating the first insulating layer 26, and having the first metal layer 22 as bottom portions are dug. The first through holes 32 can be formed with laser processing as an example. As a type of the laser processing, CO2 laser, YAG laser, and so on can be cited, but these are not limitations, and the type of the laser processing can appropriately be selected for purposes.

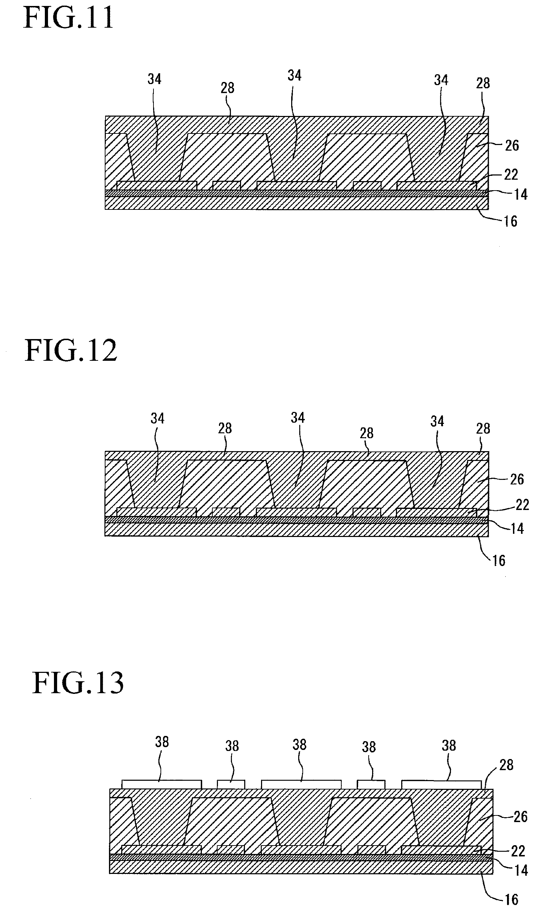

Then, as shown in Fig. 11, filled plating is performed on the insides of the first through holes 32 and the metal layer 28 with plate processing to form the first vias 34 as plated vias.

It should be noted that since the metal layer 28 becomes excessively thick with the filled plating in some cases, it is preferable to perform the half etching to adjust the thickness of the metal layer 28 to a predetermined thickness as shown in Fig. 12.

Then, as shown in Fig. 13 to Fig. 14, the second metal layer 40 is formed on the first surface 26a of the first insulating layer 26. Specifically, as shown in Fig. 13, a dry film resist 38 shaped like a film is attached to a surface of the metal layer 28 on which the half etching has been performed, and is then exposed with a predetermined pattern corresponding to the pattern of the second metal layer 40 to remove unwanted portions.

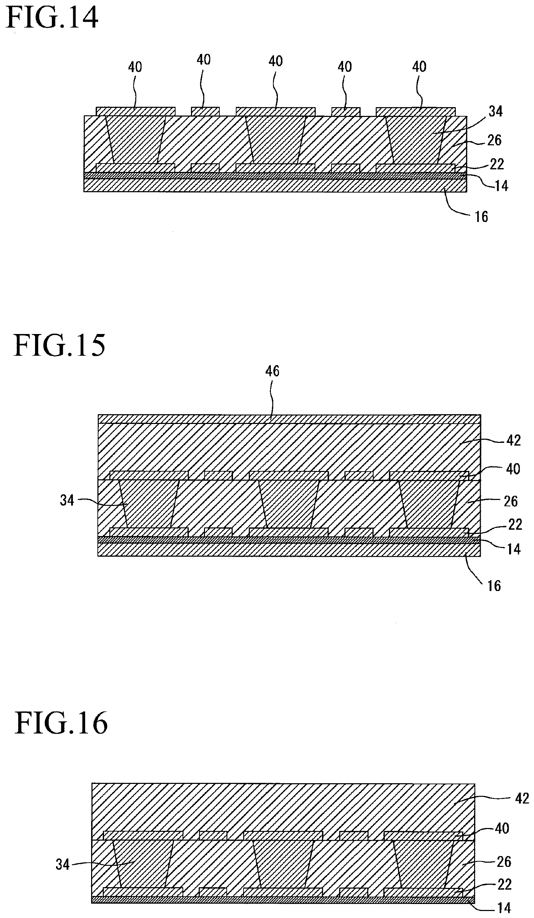

Then, as shown in Fig. 14, etching (half etching) is performed to thereby form the metal layer 28 into the second metal layer 40 shaped like a predetermined pattern, and then the dry film resist 38 is removed from the surface of the second metal layer 40.

It should be noted that the second metal layer 40 is formed to have a thickness of about 10 µm to 60 µm as an example, but this is not a limitation, and the thickness can appropriately be selected for purposes.

Further, it is possible to perform a surface roughening treatment on the second metal layer 40 to thereby improve the adhesiveness to the second insulating layer 42 when stacking the second insulating layer 42 described below.

Then, as shown in Fig. 15, the second insulating layer 42 is stacked on the first insulating layer 26 so as to bury the second metal layer 40. Further, a metal layer 46 is stacked on the second insulating layer 42, and the first insulating layer 26 and the second insulating layer 42 are pressure-bonded to each other in a state in which the metal layer 46 is stacked. Thus, the flatness of the second insulating layer 42 is ensured, and it is possible to improve the reliability of the multilayer substrate.

An average thickness of the second insulating layer 42 may be no smaller than 10 µm and no larger than 200 µm, or may be no smaller than 30 µm and no larger than 100 µm, but is not particularly limited, and can appropriately be selected for purposes.

The second insulating layer 42 is not particularly limited as long as the second insulating layer 42 is an insulating layer used in multilayer substrates, and can appropriately be selected for purposes. As an example, a base material reinforced in hardness with an inorganic base material such as inorganic woven cloth or inorganic unwoven cloth using glass cloth or the like, or an organic base material such as organic woven cloth or organic unwoven cloth can be adopted as the second insulating layer 42.

Further, specifically, as an example, a glass epoxy base material (a glass woven base material impregnated with epoxy resin, a glass unwoven base material impregnated with epoxy resin), a glass woven base material impregnated with bismaleimide triazine resin, an aramid unwoven base material impregnated with epoxy resin, and a glass woven base material impregnated with modified polyphenylene ether resin can be adopted as the second insulating layer 42.

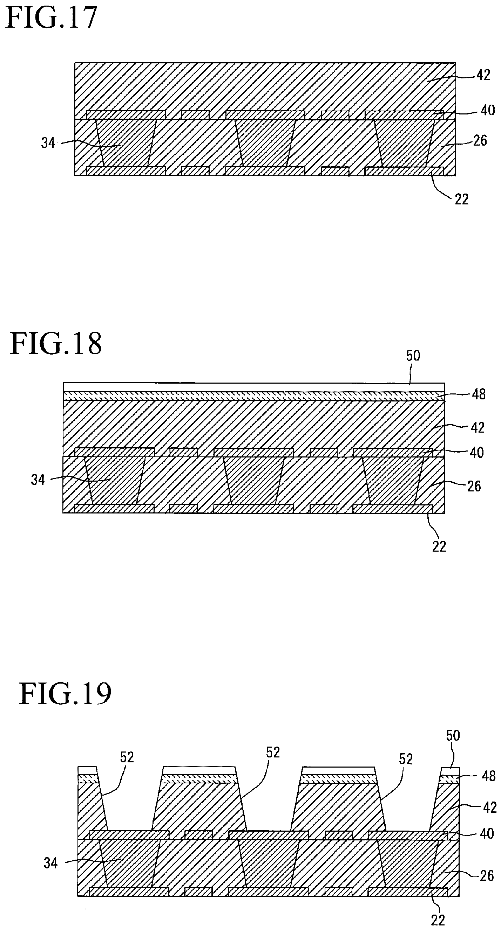

Subsequently, as shown in Fig. 16, the metal layer 46 and the metallic support body 16 located on the lower surface of the three-layer metal foil 10 are removed by etching, and then, as shown in Fig. 17, the metal foil 14 located in an intermediate layer of the three-layer metal foil 10 is removed by etching.

It should be noted that since the first metal layer 22 is exposed downward at the time point shown in Fig. 17, it is possible to perform the surface roughening treatment on the first metal layer 22 here to improve the adhesiveness to another layered body 56 when stacking on that layered body 56.

Then, as shown in Fig. 18, the third insulating layer 48 is stacked on the second insulating layer 42. More specifically, the third insulating layer 48 having a role of the adhesive layer and a resin film 50 for protecting a surface of the third insulating layer 48 are stacked on the second insulating layer 42. Further, the third insulating layer 48 and the resin film 50 may be shaped like a sheet obtained by integrating the third insulating layer 48 and the resin film 50 with each other in advance.

As the third insulating layer 48, thermosetting resin can be adopted, and as an example, glass epoxy prepreg can be adopted.

Then, as shown in Fig. 19 to Fig. 20, the second vias 54 are provided to the second insulating layer 42, the third insulating layer 48, and the resin film 50.

Specifically, as shown in Fig. 19, second through holes 52 as bottomed holes penetrating the second insulating layer 42, the third insulating layer 48, and the resin film 50, and having the second metal layer 40 as bottom portions are dug. The second through holes 52 can be formed with laser processing as an example. As a type of the laser processing, CO2 laser, YAG laser, and so on can be cited, but these are not limitations, and the type of the laser processing can appropriately be selected for purposes.

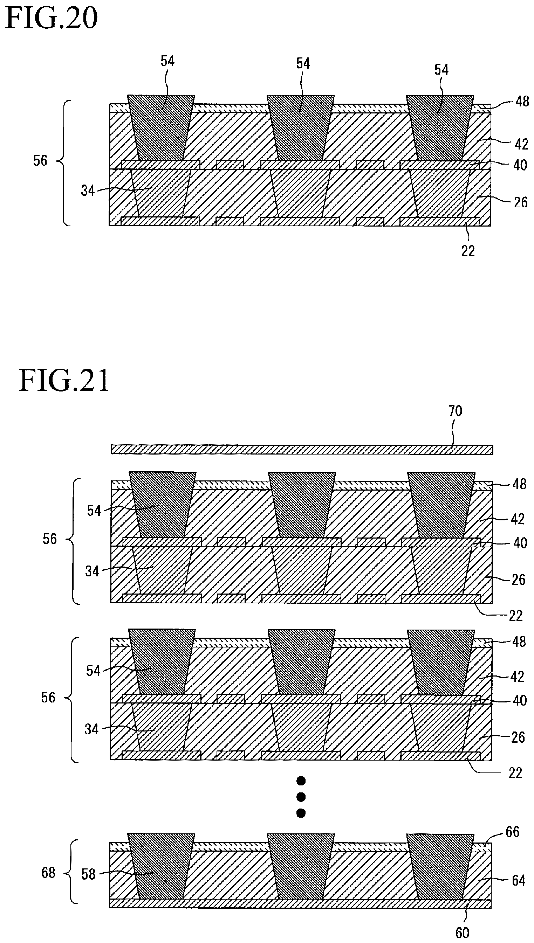

Then, as shown in Fig. 20, the second through holes 52 are filled with the conductive paste, and then, the resin film 50 is separated.

Therefore, the second vias 54 are formed as paste vias with the conductive paste 54, and since the resin film 50 is separated, the conductive paste protrudes upward from the third insulating layer 48 by the thickness of the resin film 50. Since the conductive paste protrudes from the third insulating layer 48, it is possible to reliably bond the conductive paste to the first metal layer 22 of another layered body 56.

Due to the steps so far, the layered body 56 is completed.

Subsequently, as shown in Fig. 21, the plurality of layered bodies 56 is stacked on one another. More specifically, when the number of layers of the multilayer substrate 100 is an even number (the number of metal layers included in the multilayer substrate is an even number), a metal layer 70, the plurality of layered bodies 56, and the layered body 68 are stacked on one another in this order, and are then thermocompression-bonded to each other. By performing the thermocompression bonding, the third insulating layers 48 and the fifth insulating layer 66 of the layered body 68 are cured, and the layered bodies 56, and the layered body 56 and the layered body 68 are laminated.

The example shown in Fig. 21 corresponds to when the number of layers of the multilayer substrate 100 is an even number.

It should be noted that a method for manufacturing the layered body 68 is not illustrated, but the layered body 68 is manufactured by the following method. First, the fourth insulating layer 64 and the fifth insulating layer 66 are stacked on an upper surface of a metal layer 60. However, it is preferable that a resin film (not shown) is stacked on the fifth insulating layer 66 in advance, and is then separated when the layered body 56 is stacked on the fifth insulating layer 66.

After digging bottomed through holes which penetrate the fourth insulating layer 64 and the fifth insulating layer 66 and having the metal layer 60 as bottom portions, the through holes are filled with the conductive paste to form the third vias 58 as paste vias.

The through holes can be formed with laser processing as an example. As a type of the laser processing, CO2 laser, YAG laser, and so on can be cited, but these are not limitations, and the type of the laser processing can appropriately be selected for purposes.

The fourth insulating layer 64 is not particularly limited as long as the fourth insulating layer 64 is an insulating layer used in multilayer substrates similarly to the first insulating layer 26 and the second insulating layer 42, and can appropriately be selected for purposes. As an example, a base material reinforced in hardness with an inorganic base material such as inorganic woven cloth or inorganic unwoven cloth using glass cloth or the like, or an organic base material such as organic woven cloth or organic unwoven cloth can be adopted.

Further, specifically, as an example, a glass epoxy base material (a glass woven base material impregnated with epoxy resin, a glass unwoven base material impregnated with epoxy resin), a glass woven base material impregnated with bismaleimide triazine resin, an aramid unwoven base material impregnated with epoxy resin, and a glass woven base material impregnated with modified polyphenylene ether resin can be adopted as the fourth insulating layer 64.

As the fifth insulating layer 66, thermosetting resin can be adopted, and as an example, glass epoxy prepreg can be adopted.

It should be noted that when the number of layers of the multilayer substrate 100 is an odd number (the number of metal layers included in the multilayer substrate is an odd number), the metal layer 70, the plurality of layered bodies 56, and a layered body (not shown) in which the first metal layer 22 not etched is exposed from the first insulating layer 26 are stacked on one another in this order, and are then thermocompression-bonded to each other. In either of the cases described above, the second vias 54 in one layered body 56 are electrically coupled to the metal layer 70 or the first metal layer 22 in another layered body 56.

Subsequently, as already illustrated in Fig. 1, the metal layer 70 and the metal layer 60 of the multilayer substrate 100 having been laminated (having been thermocompression-bonded) are formed into the metal layer 72 as the upper surface and the lower surface metal layer 74 shaped like predetermined patterns by etching.

Thus, the multilayer substrate 100 is completed.

The multilayer substrate 100 described above can also be used as a circuit board constituting a motherboard, an interposer, or a semiconductor element.

## Claims

1. A method for manufacturing a multilayer substrate, the method comprising:
manufacturing a layered body (56) including
etching a first foil (12) constituting a three-layer metal foil (10) to form a first metal layer (22) which is shaped like a pattern and is formed of the first foil (12),
stacking a first insulating layer (26) on the first metal layer (22) so as to bury the first metal layer (22),
stacking a metal layer (28) shaped like a flat plate on the first insulating layer (26),
forming a first through hole (32) which penetrates the metal layer (28) shaped like a flat plate and the first insulating layer (26) and reaches the first metal layer (22),
applying filled plating to the first through hole (32) to form a first via (34) as a plated via,
etching the metal layer (28) shaped like a flat plate to form a second metal layer (40) shaped like a pattern,
stacking a second insulating layer (42) on the second metal layer (40) shaped like the pattern so as to bury the second metal layer (40) shaped like the pattern,
removing a second foil (14) and a third foil (16) constituting the three-layer metal foil (10),
stacking a third insulating layer (48) and a resin film (50) on the second insulating layer (42),
forming a second through hole (52) which penetrates the third insulating layer (48), the resin film (50), and the second insulating layer (42) and reaches the second metal layer (40), and
filling the second through hole (52) with a conductive paste to form a second via (54) as a paste via; and
separating the resin films (50) in a plurality of layered bodies (56), then bonding the first insulating layer (26) of one layered body (56) and the second insulating layer (42) of another layered body (56) to each other, and then curing the third insulating layer (48) to thereby obtain the multilayer substrate (100) which is formed by stacking the plurality of layered bodies (56).

2. The method for manufacturing the multilayer substrate according to claim 1 wherein
performing half etching of reducing a thickness of the second metal layer (40) is executed after the applying the filled plating to the first through hole (32) to form the plated via.

3. The method for manufacturing the multilayer substrate according to claim 1 wherein
after the stacking the second insulating layer (42) on the second metal layer (40) shaped like the pattern so as to bury the second metal layer (40) shaped like the pattern,
stacking a metal foil (46) on the second insulating layer (42), pressure-bonding the second insulating layer (42) in a semi-cured state to the second metal layer (40) and the first insulating layer (26), and removing the metal foil (46) after the pressure-bonding are executed.
